# EUROPEAN PATENT SPECIFICATION

(11) **EP 0 650 171 B1**
(45) Date of publication and mention of the grant of the patent: **25.09.2002**
(21) Application number: 94116940.1
(22) Date of filing: 26.10.1994
(51) Int. Cl.: H01B 3/18

(54) **Insulating articles with high surface electrical resistivity and high flame resistance**
Flammfeste isolierende Gegenstände, mit hohem Oberflächenwiderstand
Articles isolant avec une résistivité superficielle élevée, résistant à la flamme

(30) Priority: 26.10.1993 IT MI932264
(43) Date of publication of application: 26.04.1995
(73) Proprietor: Basell Poliolefine Italia S.p.A., 20124 Milano (IT)
(72) Inventor: Cicchetti, Osvaldo, I-20156 Milan (IT); Pagliari, Alberto, I-20133 Milan (IT); Cipolli, Roberto, I-28100 Novara (IT); Bevilacqua, Alfonso, I-20142 Milano (IT)
(74) Representative: Zumstein, Fritz, Dr.

(56) References cited:
- EP-A- 0 349 962
- US-A- 3 810 850
- ANGEWANDTE MAKROMOLEKULARE CHEMIE, vol. 169, 1989 BASEL CH, pages 137-142, BERTELLI ET ALL. 'Structural Studies on Chars from Fire Retardant Intumescent Systems'

## Description

The present invention relates to insulating articles (i.e. electrical insulators) with high surface electrical resistivity and high flame resistance, essentially composed of a composition comprising one or more thermoplastic polymers, or polymers with elastomeric properties, preferably olefin polymers, and one or more additives selected from phosphoric acid salts of particular amine compounds.

It is known in the art that to reduce or eliminate the combustibility of said polymers one can add various types of fire resistant formulations.

For example, it is possible to add metal compounds, especially antimony, bismuth or arsenic compounds, in combination with halogenated organic compounds such as chlorinated paraffins and polybromodiphenyl ethers, which decompose at combustion temperature. Said formulations allow one to obtain satisfactory levels of flame resistance.

Considerably better results, in terms or flame resistance and reduction of toxic and/or corrosive fumes and gases during combustion, are obtained using the so-called intumescent formulations, which generally comprise organic nitrogen compounds (such as piperazine, triazine or melamine derivatives, for example) and ammonium polyphosphate. Examples of intumescent formulations of this type are described in European Patent No. 115,871.

However, as clearly demonstrated in the comparative examples of published European patent application 391 336, the surface electrical resistivity of polymer compositions containing intumescent formulations based on organic nitrogen compounds and ammonium polyphosphate undergoes considerable reduction when exposed to heat and humidity. To avoid said drawback, the above mentioned patent application suggests that in addition to said intumescent formulations, various additives selected from silane compounds, olefin rubbers, polyethylene, cross-linking agents and thiophosphites be incorporated with the polymers. The examples of said European patent application show that the above mentioned additives lessen the reduction of the surface electrical resistivity of the polymers after the latter undergo exposure to heat and humidity for 7 days. In this manner polymer compositions particularly suitable for the production of insulating articles are obtained, thanks to their high and stable surface electrical resistivity and their high flame resistance.

However, as it will be demonstrated in the comparative examples that follow, even the above formulations do not allow to maintain high levels of surface electrical resistivity when the insulating article is exposed to heat and humidity for longer than 7 days, i.e. under more aggressive accelerated aging conditions. Obviously this disadvantage limits the practical use of the insulating articles.

Now it has been found that insulating articles with improved stability of the surface electrical resistivity after prolonged exposure to heat and humidity, as well as high flame resistance, can be obtained from polymer compositions containing specific flame resistant formulations which do not contain ammonium phosphates. Moreover, these compositions show a very low tendency to migration and surface blooming of the additives comprised in the fire resistant formulation.

The insulating articles of the present invention are essentially composed of a composition comprising from 55% to 90% by weight, preferably from 60% to 85% by weight, of one or more thermoplastic polymers or polymers with elastomeric properties, preferably olefin polymers, and from 10% to 45% by weight, preferably from 15% to 40% by weight, of one or more phosphoric, pyro-(di-) or polyphosphoric acid salts of amine compounds selected from piperazine, melamine, pirazine, pyrimidine or hexahydropyrimidine and their derivatives, in which one or more hydrogen atoms have been substituted by C₁-C₂₀ alkyl or isoalkyl, C₅-C₂₀ aryl, C₆-C₂₀ arylalkyl or alkylaryl, C₃-C₈ cycloalkyl, C₄-C₂₀ cycloalkylalkyl or alkylcycloalkyl groups.

Specific examples of the above derivatives include: 2-methylpyrazine; 2-ethyl-5-phenylpyrazine; 2-cyclopentyl-6-benzylpyrazine; 2,2-dimethylpiperazine; 2-cyclohexyl-4-isopropylpiperazine; 1-methyl-3-ethylpiperazine; 1-isopropyl-4-benzylpiperazine; 2-butylpyrimidine; 5-phenylpyrimidine; 4-cyclohexyl-5-methylhexahydropyrimidine; 5,5-dimethylhexhydropyrimidine.

A preferred example of the above salts is the piperazine acid pyrophosphate; a process for its preparation is described in US Patent 4,599,375.

Other examples of salts which can be advantageously used are melamine phosphate and melamine pyrophosphate, also described in US Patent 4,599,375.

Said U.S. patent describes highly flame resistant polymer compositions containing the above mentioned piperazine and melamine salts. However the use of said compositions for insulating articles is not disclosed.

Particularly preferred, within the scope of the present invention, are the insulating articles essentially composed of a composition comprising (percentage by weight):
- from 55 to 90%, preferably from 60 to 85%, of one or more thermoplastic polymers, or polymers with elastomeric properties, preferably olefin polymers;
- from 10 to 45%, preferably from 15 to 40%, of piperazine acid pyrophosphate;
- from 0% to 35%, preferably from 5% to 30% of melamine phosphate or pyrophosphate;
where the sum of the weight percentages of the above components is 100%.

The above salts can be easily prepared, for example, by reaction of the phosphoric acid and the amine compound in water, as demonstrated in the examples of the above mentioned U.S. Patent 4,599,375.

In addition to the above mentioned components it is possible to add to the polymer compositions which are used according to the present invention, other additives known in the art, such as antioxidants, UV and process stabilizers, pigments, opacifiers and fillers, in quantities equal in weight to the amount of polymer being replaced.

It is also possible to add to the polymer compositions various nitrogen compounds having the effect of flame retardants, such as ethylene urea; hydantoin; barbituric acid; uric acid; polyvinylpyridine; urea-formaldehyde, or ethylene urea-formaldehyde, or melamine-formaldehyde, or anilino-formaldehyde resins; guanidine; dicyandiamide; 1,3,5-triazine or hexahydrotriazine; and their alkyl, aryl, cycloalkyl or alkylene derivatives.

Said nitrogen compounds can partially replace (up to 10% by weight for example) the above mentioned amine compound salts of phosphoric acids.

The polymers that can be used to prepare the polymer compositions comprise homopolymers and copolymers, or blends thereof, obtained by mechanical blending or sequential polymerization, of olefins of formula R-CH=CH₂, where R is H, or a C₁-C₆ alkyl, or an aryl radical.

Examples of such polymers include:
1) isotactic or mostly isotactic polypropylene;
2) HDPE, LLDPE, and LDPE polyethylene;
3) crystalline copolymers of propylene with ethylene and/or other α-olefins, such as 1-butene, 1-hexene, 1-octene and 4-methyl-pentene;
4) ethylene/α-olefin elastomeric copolymers and ethylene/α-olefin/diene terpolymers containing minor proportions of diene, where the α-olefin is preferably selected from propylene, 1-butene, 1-pentene, 1-hexene, 4-methyl-1-pentene and 3-methyl-1-butene; examples of dienes most commonly present in said elastomeric copolymers are butadiene, ethylidene-norbornene and 1-4-hexadiene;
5) heterophasic polymers obtained by mechanical blending or sequential polymerization, comprising a fraction constituted by a propylene homopolymer or the copolymers of item 3), and a copolymer fraction constituted by the elastomeric copolymers of item 4);
6) polymers obtained from di-olefins and cycloolefins, such as polyisoprene, polybutadiene, polycyclopentene, polynorbornene;
7) polystyrene.

Other examples of polymers commonly used are polyamide resins, polyurethane (polyester and polyether), polyethylene terephthalate and polybutylene terephthalate, and acrylonitrile-butadiene-styrene (ABS) and styrene-acrylonitrile (SAN) copolymers.

The polymer compositions to be used for the realization of the insulating products of the present invention can be prepared according to conventional methods, such as for example by blending the polymer with the other components in a dry mixer and extruding the blend at an extruder temperature which is the most suited for obtaining a pelletized product. Preferably the above mentioned salts of amine compounds with phosphoric acids are added to the blend in the form of powders having a particle size of less than 100 micrometers.

Examples of insulating articles which can be obtained from the above polymer compositions are dielectric sheets and films (to use as dielectrics for condensers or as bases for printed circuits, for example), insulation for electric cables and conductors in general (such as circuit insulators, for example), internal components of electrical or electronic apparatus, or electric line insulators. Generally speaking, the present invention comprises electrical insulating articles useful where a high surface electrical resistivity which is constant in time even after exposure to heat and humidity, and a high flame resistance are needed.

Said articles can be prepared by conventional techniques, such as extrusion, film extrusion and injection molding, for example.

The following examples are given in order to illustrate and not limit the present invention, and they describe the preparation of polymer compositions which can be used for the manufacture of the insulating articles of the invention. Moreover, the autoextinguishing levels, blooming times and surface electrical resistivity are determined by using standard specimens obtained from the above mentioned compositions. The values determined in this way are obviously representative of the characteristics of the finished insulating articles. In particular, the surface electrical resistivity values of the finished insulating articles do not vary significantly from those obtained from the specimens.

### Example 1

A heterophasic propylene/ethylene copolymer, Moplen EPT 30 R (marketed by Himont), comprising 8% by weight of ethylene and having a Melt Flow Rate (MFR/L according to ASTM D 1238 condition L) of 3.5 g/10 min., is dry blended in a Henschel mixer with the following additives in the proportions indicated (percentages by weight):
- 71.7% Moplen EPT 30R
- 28% PAP (Piperazine Acid Pyrophosphate);
- 0.3% Irganox B225 stabilizer marketed by Ciba-Geigy, and comprising tris(2,4-di-tert-butylphenyl)phosphite and tetrakis [methylene(3,5-di-tert-butyl-4-hydroxyhydrocinnamate)] methane in equal parts.

The resulting composition is extruded at about 200°C and then pelletized with a Werner twin-screw extruder having an inside diameter of the cylinder of 28 mm.

### Example 2

Example 1 is repeated using 20% by weight of PAP and 8% by weight of MEP (melamine phosphate) instead of 28% by weight of PAP alone.

### Example 3

The following composition is prepared with a Henschel mixer (percentages by weight):
- 51.7% Moplen EPT 30R;
- 10% High density polyethylene Eraclene HQG 6015, marketed by Enichem, MFR = 7 g/10 min.;
- 10% EPR Dutral CO 054 rubber, marketed by Enichem;
- 28% PAP/MEP mixture as in Example 2;
- 0.3% Irganox B 225.

### Comparative example 1

Example 1 is repeated using 11% by weight of PAP and 17% by weight of APP (ammonium polyphosphate Hostaflam AP marketed by Hoechst) instead of 28% by weight of PAP alone.

### Comparative example 2

The following composition is prepared with a Henschel mixer (percentage by weight):
- 74.3% Moplen EPT 30R;
- 6.4% poly-2-piperazilene-4-morpholine-1,3,5-triazine Spinflam MF 82 marketed by Himont;
- 19% Hostaflam AP;
- 0.3% Irganox B 225.

The composition is then extruded and pelletized as in Example 1.

### Comparative example 3

In a Henschel mixer a composition of the type described in published European patent application 391336 is prepared, said composition comprising (percentages by weight):
- 51.4% Moplen EPT 30 R;
- 10% HQG 6015;
- 10% Dutral CO 054;
- 7% Spinflam MF 82;
- 21% Hostaflam AP;
- 0.3% vinyltriethoxysilane Silane A 171 marketed by Union Carbide;
- 0.3 Irganox B 225

The composition is then extruded and pelletized as in Example 1.

The pellets obtained in the preceding examples are dried at 100°C for 3 hours and injection molded (maximum temperature of the extruder cylinder = 220°C) to form specimens with the dimensions required for the standard measuring methods described below.

### Blooming and surface electrical resistivity

Circular specimens 2 mm thick (100 mm diameter) are placed in a controlled-atmosphere apparatus set at 80°C with a relative humidity of 80%.

Said specimens, removed from the apparatus at specific time intervals (7, 14, 21, 28 and 42 days), are dried for 2 hours in an 80°C oven and, after a 12-hour conditioning period in a dryer at ambient temperature, they are visually examined to check for surface blooming. The surface electrical resistivity of the specimens is measured by means of a high resistance meter (Hewlett Packard HP 4329 AA), according to ASTM D-257. The results obtained are shown in the Table.

### Flame Resistance

This determination is done using two methods:
- the UL 94 (Underwriters Laboratories) vertical burning test method, which assigns the V2, V1, and V0 classifications (indicating increasing levels of flame resistance) after 2 successive ignitions, and the 5V classification after 5 successive ignitions;
- ASTM D-2863 to measure the LOI (Limited Oxygen Index) values % on specimens 3.2 mm thick.

The results are shown in the Table.

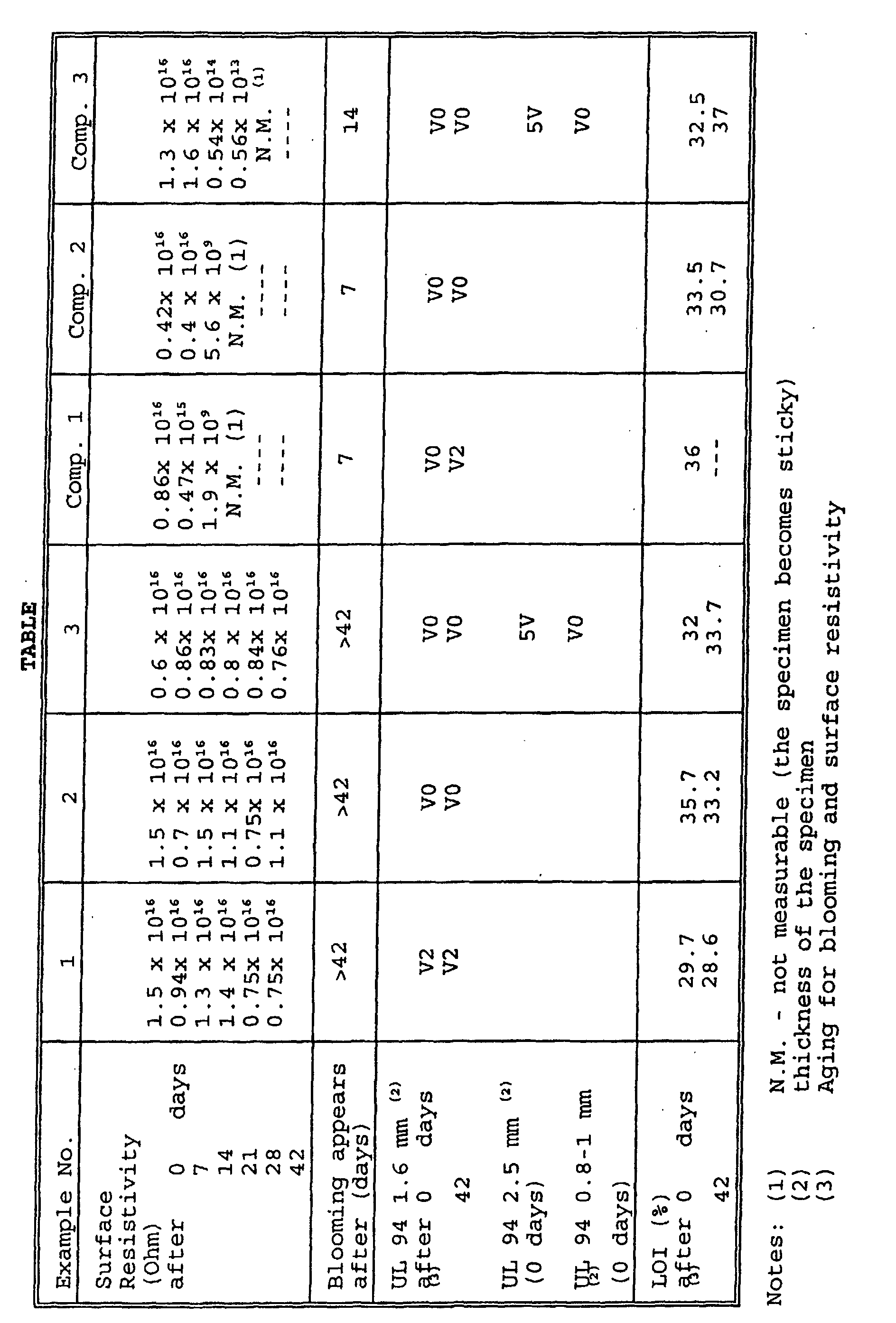

The results set forth in the Table show clearly that the compositions that can be used for the manufacture of the electrical insulating articles of the present invention possess high levels of resistance to flame and blooming, and above all they show high levels of surface resistance without substantial decrease of said resistance even after 42 days of aging.

## Claims

1. Use, for achieving electrical insulation, flame resistance and stability of the surface electric resistivity after exposure of the test material to relative humidity of 80% at 80 °C for longer than 7 days, in the form of 2 mm thick specimens, followed by drying and 12-hour conditioning at ambient temperature, of 10% to 45% by weight of one or more phosphoric, pyro- (di-) or polyphosphoric acid salts of amine compounds selected from piperazine, melamine, pirazine, pyrimidine or hexahydropyrimidine and their derivatives, in which derivatives one or more hydrogen atoms have been substituted by C₁-C₂₀ alkyl or isoalkyl, C₅-C₂₀ aryl, C₆-C₂₀ arylalkyl or alkylaryl, C₃-C₈ cycloalkyl, C₄-C₂₀ cycloalkylalkyl or alkylcycloalkyl groups, as additives in electrical insulating articles which do not contain ammonium phosphates, composed of 55% to 90% by weight of one or more thermoplastic polymers or polymers with elastomeric properties, selected from homopolymers, copolymers or blends thereof, obtained by mechanical blending or sequential polymerization, of olefins of formula R-CH=CH₂, wherein R is hydrogen, or a C₁-C₆ alkyl, or an aryl radical.

2. Use of the piperazine acid pyrophosphate as additive according to claim 1 in electrical insulating articles essentially composed of a composition comprising (percentages by weight):
- from 55% to 90% of one or more thermoplastic polymers or polymers with elastomeric properties;
- from 10% to 45% of piperazine acid pyrophosphate;
- from 0% to 35% of melamine phosphate or pyrophosphate;
wherein the sum of the above components is 100%.

3. Use of the additives according to claim 1 in electrically insulating articles in the form of a dielectric sheet or film, an insulation for electric cables and conductors, an internal component of electrical or electronic apparatus, or an electric line insulator.

## Patentansprüche

1. Verwendung zur Erzielung von elektrischer Isolierung, Flammbeständigkeit und Stabilität des elektrischen Oberflächenwiderstands nach Einwirken von relativer Feuchtigkeit von 80% bei 80°C während länger als 7 Tagen auf das Testmaterial in Form von 2mm dicken Proben, anschließendem Trocknen und 12stündiger Konditionierung bei Raumtemperatur von 10 bis 45 Gew.% von einem oder mehreren Phosphorsäure-, Pyro(di)- oder Polyphosphorsäuresalzen von Aminverbindungen, ausgewählt unter Piperazin, Melamin, Pyrazin, Pyrimidin oder Hexahydropyrimidin und deren Derivaten, wobei in den Derivaten eines oder mehrere Wasserstoffatome durch C₁-C₂₀-Alkyl- oder Isoalkyl-, C₅-C₂₀-Aryl-, C₆-C₂₀-Aralkyl- oder Alkaryl-, C₃-C₈-Cycloalkyl-, C₄-C₂₀-Cycloalkylalkyloder Alkylcycloalkylgruppen substituiert sind, als Additive in elektrisch isolierenden Erzeugnissen, die keine Ammoniumphosphate enthalten, bestehend aus 55-90 Gew.% von einem oder mehreren thermoplastischen Polymeren oder Polymeren mit elastomeren Eigenschaften, ausgewählt unter Homopolymeren, Copolymeren oder deren Mischungen, erhalten durch mechanisches Mischen oder stufenweise Polymerisation von Olefinen der Formel R-CH=CH₂, worin R Wasserstoff oder ein C₁-C₆-Alkyl oder ein Arylrest ist.

2. Verwendung von saurem Pyrophosphat des Piperazins als Additiv gemäß Anspruch 1 in elektrisch isolierenden Erzeugnissen, im wesentlichen bestehend aus einer Zusammensetzung, umfassend (Gewichtsprozente):
- 55 bis 90% von einem oder mehreren thermoplastischen Polymeren oder Polymeren mit elastomeren Eigenschaften;
- 10 bis 45% saures Pyrophosphat des Piperazins;
- 0 bis 35% Melaminphosphat oder -pyrophosphat;
worin die Summe der vorstehenden Komponenten 100% ausmacht.

3. Verwendung der Additive gemäß Anspruch 1 in elektrisch isolierenden Erzeugnissen in Form einer dielektrischen Folie oder eines dielektrischen Films, einer Isolierung für Elektrokabel und Leiter, einer eingebauten Komponente einer elektrischen oder elektronischen Apparatur oder eines elektrischen Leitungsisolators.

## Revendications

1. Utilisation, pour la réalisation d'une isolation électrique, d'une résistance à la flamme et d'une stabilité de la résistivité électrique surfacique après exposition d'échantillons de matériaux sous la forme d'éprouvettes d'une épaisseur de 2 mm à une humidité relative de 80% à 80°C pour une durée excédant 7 jours, suivie d'un séchage et d'un maintien à température ambiante pendant 12 heures, de 10 à 45% en poids d'un ou plusieurs sels d'acide phosphorique, pyro-(di-) ou polyphosphorique de composés amine choisies parmi la pipérazine, mélamine, pirazine, pyrimidine ou hexahydropyrimidine et leurs dérivés, dans lesquels dérivés un ou plusieurs atomes d'hydrogène ont été remplacés par un groupe alkyle ou isoalkyle en C₁₋₂₀, un groupe aryle en C₅₋₂₀, un groupe arylalkyle ou alkylaryle en C₆₋₂₀, un groupe cycloalkyle en C₃₋₈, un groupe cycloalkylalkyle ou alkylcycloalkyle en C₄₋₂₀, comme additifs dans des articles électriquement isolants ne contenant pas de phosphates d'ammonium, composés de 55 à 90% en poids d'un ou plusieurs polymères thermoplastiques ou de polymères avec des propriétés élastomériques, choisis parmi les homopolymères, copolymères ou leurs mélanges, obtenus par malaxage mécanique ou polymérisation séquentielle d'oléfines de formule R-CH=CH₂, dans laquelle R est hydrogène, ou un groupe alkyle en C₁₋₆ ou un groupe aryle.

2. Utilisation du pyrophosphate acide de pipérazine comme additif selon la revendication 1 dans des articles électriquement isolants sensiblement composés d'une composition comprenant ( en poids) :
- de 55% à 90% d'un ou plusieurs polymères thermoplastiques ou polymères ayant des propriétés élastomériques ;
- de 10% à 45% de pyrophosphate acide de pipérazine;
- de 0% à 35% de pyrophosphate ou phosphate de mélamine ;
la somme des composantes ci-dessus étant 100%.

3. Utilisation des additifs selon la revendication 1 dans des articles électriquement isolants ayant la forme d'une feuille ou film diélectrique, d'une isolation de câbles ou de conducteurs électriques, d'un composant interne de dispositifs électriques ou électroniques, ou d'un isolant de la ligne électrique.
